# EUROPEAN PATENT SPECIFICATION

(11) **EP 3 094 685 B1**
(45) Date of publication and mention of the grant of the patent: **06.03.2019**
(21) Application number: 14878490.3
(22) Date of filing: 17.01.2014
(51) Int. Cl.: C08L 83/05, C08K 5/3477, H01L 23/28, H01L 23/29

(54) **CURABLE COMPOSITION FOR OPTICAL SEMICONDUCTOR DEVICES**
HÄRTBARE ZUSAMMENSETZUNG FÜR OPTISCHE HALBLEITERBAUELEMENTE
COMPOSITION DURCISSABLE POUR DISPOSITIFS À SEMI-CONDUCTEURS OPTIQUES

(43) Date of publication of application: 23.11.2016
(73) Proprietor: Henkel AG & Co. KGaA, 40589 Düsseldorf (DE)
(72) Inventor: WU, Hao, Shanghai 200032 (CN); ZHANG, Yong, Shanghai 201203 (CN); TAN, Wenjuan, Shanghai 201203 (CN); LI, Zhiming, Shanghai (CN)
(86) International application number: PCT/CN2014/070806
(87) International publication number: WO 2015/106438

(56) References cited:
- EP-A1- 2 620 441
- WO-A1-2006/057218
- JP-A- 2004 131 518
- JP-A- 2005 136 379
- JP-A- 2006 213 899
- JP-A- 2012 052 025

## Description

### Field of the Invention

The present invention relates to a curable composition for optical semiconductor devices. The curable composition after curing exhibits good mechanical properties, barrier properties, heat resistance and light resistance. The present invention further relates to the use of the curable composition in production of an optically semiconductor device.

### Background Art

For light emitting devices such as light emitting diodes (LEDs) and photo coupler, a composition for sealing the light emitting element is required to provide the element with high thermal stability and UV stability.

Optical materials in electric and optical applications have attracted considerable attention in recent years. In the electric and optical application, the materials need to have good UV resistance, thermal aging, high transmittance, and barrier properties. These requirements are very critical and need to be fulfilled by the organic materials used. Previously, mainly epoxy resin was used as the optical material; it shows good mechanical and barrier properties. But it is prone to yellowing under exposure to UV light and/or high temperatures. That is why it was substituted by silicone material. Organopolysiloxane compositions show better heat stability and light stability than those of epoxy systems. But its barrier property is poor. So materials which have good UV/thermal resistance and good barrier properties are mostly wanted for optical applications, especially for LED applications.

Many references deal with such silicone compositions and their use for LED manufacturing.

JP 2003113310 provides a composition comprising: (A) an organic compound which contains in a molecule thereof at least two carbon - carbon double bonds showing reactivity with a SiH group, (B) a silicon compound which contains at least two SiH groups in one molecule, wherein the component (B) is a reaction product from 1,3,5,7-tetramethylcyclotetrasiloxane and triallyl isocyanurate, (C) a hydrosilylation catalyst, (D) a silane coupling agent, and (E) a silanol condensation catalyst. The elongation of the cured compositions according to the examples is less than 20%. The toughness is poor and the cured compositions easily crack when used as encapsulant in an LED cup.

JP 2012052025 provides a composition comprising: (A) organic compounds having ≥2 SiH-reactive C-C double bonds, (B) linear polyorganosiloxanes having ≥2 SiH groups and a weight average molecular weight Mw from 500 to10,000 g/mol, (C) compatibilizers, (D) hydrosilylation catalysts. To overcome compatibility problems of the compounds used in this system, compatibilizers must be used. This imposes severe limitations to adjust the formulation.

JP 2006213899 provides a composition comprising: (A) organic compound which contains at least two carbon double bond in 1 molecules which possesses reactivity with a SiH group, (B) a chemical compound which at least contains two SiH groups per molecule, (C) a hydrosilylation catalyst, and (D) a solid component having a low modulus of elasticity . The formulation needs to comprise the solid component of low modulus of elasticity such as silicone rubber particles, modacrylic rubber particles, butadiene rubber particles or fluorine rubber particles. This again imposes limitations on the possibilities to adjust the formulation.

WO 2006057218 discloses compositions comprising: (A) an organic compound having ≥2 C=C bonds reactive with an SiH group, (B) a compound having ≥2 SiH groups, (C) a hydrosilylation catalyst, and (D) rubber particles coated with an acrylic resin. The formulation needs to comprise the rubber coated with an acrylic resin. This will decrease the thermal stability. EP2620441 discloses a composition for an optical semiconductor device based on the hydrosilylation reaction product of an alkenyl-group-containing polyhedral siloxane, an alkenyl-functional organic silicone compound and a hydrosilyl-group-containing compound, which undergoes further hydrosilylation crosslinking reaction with an isocyanurate, e.g. triallylisocyanurate.

From the above documents, it can be seen that organopolysiloxane compositions are widely used as LED encapsulant material. Organopolysiloxane compositions show better heat stability and light stability but its barrier property is poor. Moreover, in compositions known in the prior art, normally specific additives, like hardener orcompatibilizers are needed to improve the performance.

Thus, materials which have good UV/thermal resistance and good barrier properties and which do not need addition of specific additives, are still needed for optical applications, especially for LED applications.

### Summary of the Invention

The present invention relates to a curable composition, comprising: a) at least one organic compound having two or more carbon-carbon double bonds which is represented by formula (1) 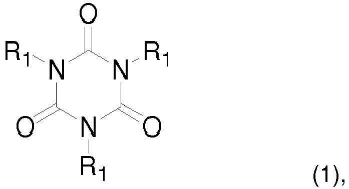 wherein R₁ at each occurrence independently from each other represents a monovalent organic group having 1 to 20 carbon atoms, b) at least one silicon hydride compound comprising at least two hydrogen atoms each directly bonded to a silicon atom and at least one aryl or arylene group per molecule, and c) at least one hydrosilylation catalyst. The curable composition after curing exhibits good mechanical properties, barrier properties, heat resistance and light resistance.

The present invention further encompasses the use of the curable composition in the production of an optically semiconductor device, in particular as an encapsulant, adhesive or lens material in the production of LEDs.

### Detailed Description of the Invention

In the following passages the present invention is described in more detail. Each aspect so described may be combined with any other aspect or aspects unless clearly indicated to the contrary. In particular, any feature indicated as being preferred or advantageous may be combined with any other feature or features indicated as being preferred or advantageous.

In the context of the present invention, the terms used are to be construed in accordance with the following definitions, unless a context dictates otherwise.

As used herein, the singular forms "a", "an" and "the" include both singular and plural referents unless the context clearly dictates otherwise.

The terms "comprising", "comprises" and "comprised of" as used herein are synonymous with "including", "includes" or "containing", "contains", and are inclusive or open-ended and do not exclude additional, non-recited members, elements or method steps.

The recitation of numerical end points includes all numbers and fractions subsumed within the respective ranges, as well as the recited end points.

Unless otherwise defined, all terms used in the disclosing the invention, including technical and scientific terms, have the meaning as commonly understood by one of the ordinary skill in the art to which this invention belongs to. By means of further guidance, term definitions are included to better appreciate the teaching of the present invention.

The present invention provides a curable composition, comprising: a) at least one organic compound having two or more carbon-carbon double bonds which is represented by formula (1) 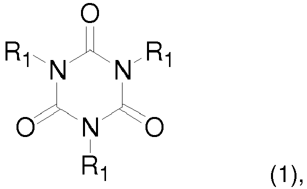 wherein R₁ at each occurrence independently from each other represents a monovalent organic group having 1 to 20 carbon atoms, b) at least one silicon hydride compound comprising at least two hydrogen atoms each directly bonded to a silicon atom and at least one aryl or arylene group per molecule, and c) at least one hydrosilylation catalyst. The curable composition provides cured products showing good mechanical properties, barrier properties, heat resistance, and light resistance.

A "curable composition" is understood to be a mixture of two or more substances which mixture can be converted from a soft state into a harder state by means of physical or chemical actions. Those physical or chemical actions can consist, for example, in the delivery of energy in the form of heat, light, or other electromagnetic radiation, but also in simply bringing into contact with atmospheric moisture, water, or a reactive component. Preferably, the composition of the present invention is heat-curable.

A curable composition according to the present invention comprises an organic compound having two or more carbon-carbon double bonds which is represented by formula (1) 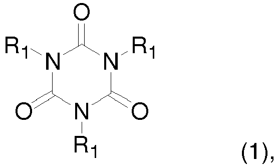 wherein R₁ at each occurrence independently from each other represents a monovalent organic group having 1 to 20 carbon atoms.

It is apparent from formula (1) that the required carbon-carbon double bonds need to be part of the the substituents R₁. It is possible that one substituent R₁ comprises 2 carbon-carbon double bonds not directly linked to each other and the remaining substituents R₁ do not comprise a carbon-carbon double bond. However, it is preferred that at least two substituents R₁, preferably all three substituents R₁, comprise at least one carbon-carbon double bond each. Preferably, the carbon-carbon double bond(s) is/are located at the terminus of the substituent(s) R₁.

Hence, preferably, in formula (1) at least two R₁, preferably all three substituents R₁, are selected from alkenyl groups and alkoxy alkyl groups bearing a terminal vinyl group, particularly preferred from alkenyl groups. It is possible that the alkenyl groups and alkoxy alkyl groups bear one or more halogen atoms.

Preferred alkenyl groups are selected from vinyl, allyl, 3-butenyl, 5-hexenyl, and 9-decenyl, preferably from allyl, 5-hexenyl, and 9-decenyl, particular preferred allyl. Preferred alkoxy alkyl groups are selected from vinyloxymethyl, allyloxymethyl vinyloxyethyl, and allyloxyethyl, particular preferred allyloxyethyl.

Most preferably, the organic compound of formula (1) is triallyl isocyanurate being represented by the following formula:

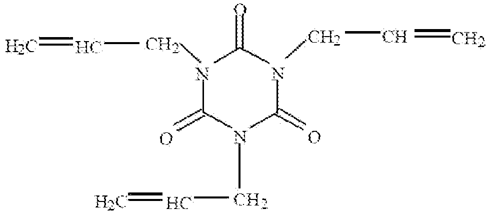

Triallyl isocyanurate (C₁₂H₁₅N₃O₃; mol. wt. = 249.30), also called 1,3,5-triallylisocyanuric acid; or TAIC, is a commercially available compound, usually used as a crosslinking agent in the manufacture of synthetic rubbers, flame retardants, and agrochemicals. The brominated form is marketed as a flame retardant for olefin and styrene resins, providing heat and weather resistance, good dispersability, and high heat stability (to prevent yellowing).

Triallyl isocyanurate has three C-C double bonds and is able to react with silicone material which has at least one Si-H group in a hydrosilylation reaction. Triallyl isocyanurate showsgood compatibility with silicone systems and gives good transparency when such system is cured. Triallyl isocyanurate has a triazine ring, which is stable under heat and light. So presence of this compound in a curable silicone based composition does not decrease the heat /UV stability of the hybrid material resulting therefrom upon curing.

Therefore, the inventors introduced organic compounds of formula (1) and in particular triallyl isocyanurate into the field of silicone chemicals. Compared to pure silicone material, it is found that triallyl isocyanurate improves the mechanical properties and barrier properties a lot, and thereby overcomes the shortcomings of silicone material. Due to these good properties, this kind of hybrid material is beneficial for the application in production of optically semiconductor devices.

Triallyl isocyanurate is available commercially from the following sources: Sinopharm chemical reagent Co.Ltd. (China); Interbusiness Group, USA, Inc. (New York, NY); Monomer-Polymer & Dejac Labs, Inc. (Feasterville, PA); Nipa Hardwicke, Inc. (Wilmington, DE); Itochu Specialty Chemicals, Inc. (White Plains, NY); Azko-Nobel Chemicals, Inc. (Chicago, IL); and Aldrich Chemical Co. (Milwaukee, WI). It is also available from Nippon Kasai Chemical Company, Ltd. (Japan) (CW Buyer's Guide, 1998). The brominated form, known as Firecut-66 (Anon., 1986), is available from Suzuhiro Chemical (Japan).

The curable composition according to the present invention preferably comprises from 2 to 55 % by weight of the organic compound of formula (1), based on the total weight of the curable composition.

The curable composition according to the present invention further comprises at least one silicon hydride compound comprising at least two hydrogen atoms each directly bonded to a silicon atom and at least one aryl or arylene group per molecule.

The silicon hydride compound is preferably represented by the average compositional formula (2):

R²ₐH_{b}SiO_{(4-a-b)/2} (2),

wherein R² is a monovalent organic group, selected from alkyl groups, aryl groups and arylene groups; "a" is a positive number of 0.7 to 2.1, "b" is a positive number of 0.001 to 1.0, and the sum of a+b is 0.8 to 3. At least part of R² needs to be aryl or arylene to ensure that the silicon hydride compound comprises at least one aryl or arylene group per molecule.

It is preferred that the alkyl group is an alkyl group of 1 to 10 carbon atoms, preferably selected from methyl, ethyl, n-propyl, isopropyl, n-butyl, isobutyl, tert.-butyl, n-pentyl, isopentyl, 2,2-dimethylpropyl, n-hexyl, isohexyl, 2,2-dimethylbutyl, n-octyl, n-nonyl, and n-decyl, particularly preferred selected from methyl, and ethyl, most preferred methyl.

The preferred aryl group is an aryl group of 6 to 10 carbon atoms, preferably selected from phenyl and benzyl, most preferred phenyl.

The preferred arylene group is an arylene group of 6 to 10 carbon atoms, preferably selected from phenylene and benzylene, most preferred phenylene.

It is particularly preferred that part of R² designates methyl, and the remaining part of R² designates phenyl.

Particularly preferred the silicon hydride compound is selected from 1,1,5,5-tetramethyl-3,3-diphenyl-trisiloxane, 1,1,7,7-tetramethyl-3,3,5,5-tetraphenyltetrasiloxane;
Hydride terminated polyphenyl-(dimethylsiloxy)siloxane;
Hydride terminated polyphenylene-(dimethylsiloxy)siloxane; and mixtures thereof.

Most preferred the silicon hydride compound is 1,1,5,5-tetramethyl-3,3-diphenyl-trisiloxane.

The curable composition according to the present invention preferably comprises from 45 to 98 % by weight of the silicon hydride compound, based on the total weight of the curable composition.

The curable composition according to the present invention comprises a hydrosilylation catalyst.

The term "Hydrosilylation" describes the addition of Si-H bonds across unsaturated bonds. Ordinarily the reaction is conducted catalytically and usually the substrates are unsaturated organic compounds. Alkenes and alkynes give alkyl and vinyl silanes; aldehydes and ketones give silyl ethers.

Suitable hydrosilylation catalysts to be used in the present invention are platinum catalysts, for example chloroplatinic acid, allylsiloxane-platinum complex catalyst, supported platinum catalysts, methylvinylsiloxane-platinum complex catalysts, reaction products of dicarbonyldichloroplatinum and 2,4,6-triethyl-2,4,6-trimethylcyclotrisiloxane.

Preferably, the hydrosilylation catalyst is selected from allylsiloxane-platinum complex catalyst, methylvinylsiloxane-platinum complex catalysts.

Preferably, the curable composition comprises a platinum based hydrosilylation catalyst in an amount that the platinum content calculated as platinum metal is 1 to 500 ppm, and more preferably 2 to 100 ppm, based on the total weight of the curable composition. ppm is to be understood as parts per million by weight.

Preferably, the curable composition according to the present invention comprises from 0.0001 to 0.05 % by weight of the hydrosilylation catalyst, based on the total weight of the curable composition.

Preferably, the curable composition comprises:
a) from 2 to 55 % by weight of the organic compound,
b) from 45 to 98 % by weight of the silicon hydride compound,
c) from 0.0001 to 0.05 % by weight of the hydrosilylation catalyst
wherein the amount of all components a) to c) sums up to 100 wt-%.

However, the curable composition according to the invention may comprise further compounds and additives insofar as the objects of the invention are not compromised.

Possible additives include addition reaction inhibitors for adjusting curing time and imparting a pot life, and adhesion promoters to improve the adhesive properties of the composition. Further additives include plasticizers, stabilizers, antioxidants, reactive diluents, drying agents, UV stabilizers, anti-ageing agents, rheological auxiliaries, fungicides and/or flame retardants.

Suitable reaction inhibitors include ethynylcyclohexanol, 2-methyl-3-butyn-2-ol, 3,5-dimethyl-1-hexyn-3-ol, 2-phenyl-3-butyn-2-ol, or similar alkyne alcohols; 3-methyl-3-penten-1-yne, 3,5-dimethyl-3-hexen-1-yne, or a similar enyne compound; 1,3,5,7-tetramethyl-1,3,5,7-tetravinyl-cyclotetrasiloxane, 1,3,5,7-tetramethyl-1,3,5,7-tetrahexenyl-cyclotetrasiloxane, benzotriazole, or the like. There are no special restrictions with regard to the quantities in which these inhibitors can be added but it may be recommended that in terms of weight units these inhibitors be added in a quantity of 10 to 1,000 ppm per weight of the composition.

An adhesion promoter is understood to mean a substance that improves the adhesion properties of the composition on surfaces. Conventional adhesion promoters (tackifiers) known to the person skilled in the art can be used individually or as a combination of several compounds. Suitable examples include resins, terpene oligomers, coumarone/indene resins, aliphatic petrochemical resins and modified phenolic resins. Suitable within the framework of the present invention are, for example, hydrocarbon resins, as obtained by polymerization of terpenes, mainly α- or β-pinene, dipentene or limonene. Polymerization of these monomers is usually cationic with initiation using Friedel-Crafts catalysts. The terpene resins also include copolymers of terpenes and other monomers, such as styrene, α-methylstyrene, isoprene and the like. The above-mentioned resins are used, for example, as adhesion promoters for pressure-sensitive adhesives and coating materials. Also suitable are the terpene phenolic resins, which are produced by acid-catalyzed addition of phenols to terpenes or rosin. Terpene phenolic resins are soluble in most organic solvents and oils and miscible with other resins, waxes and rubber. Also suitable as adhesion promoters within the framework of the present invention in the above sense are the rosins and their derivatives, such as esters or alcohols thereof. Particularly suitable are silane adhesion promoters, in particular aminosilanes and epoxysilanes, for example 3,4-epoxycyclohexylethyl trimethoxysilane.

Furthermore, the curable composition according to the present invention may optionally comprise an organopolysiloxane represented by formula (3):

(R³R⁴R⁵SiO_{1/2})_{M}·(R⁶R⁷SiO_{2/2})_{D}·(R⁸SiO_{3/2})_{T}·(SiO_{4/2})_{Q} (3),

wherein R³ to R⁸ are identical or different groups independently from each other selected from alkyl groups, alkenyl groups and aryl groups, at least one of R³ to R⁸ is an alkenyl group, at least one of R³ to R⁸ is an aryl group, and on average at least two alkenyl groups and at least one aryl group are contained in each organopolysiloxane molecule; M, D and Q each represent a number ranging from 0 to less than 1, 0< T <1 and M+D+T+Q = 1.

Preferably, R³ to R⁸ each independently are linear or branched C1-C20 alkyl or C2-C20 alkenyl groups, or halides of such linear or branched alkyl or alkenyl groups, or cycloalkyl groups or cycloalkenyl groups having 5-25 carbon atoms, respectively, or halides of such cycloalkyl groups or cycloalkenyl groups.

It is further preferred that the alkyl group is an alkyl group of 1 to 10 carbon atoms, preferably selected from methyl, ethyl, n-propyl, isopropyl, n-butyl, isobutyl, tert.-butyl, n-pentyl, isopentyl, 2,2-dimethylpropyl, n-hexyl, isohexyl, 2,2-dimethylbutyl, n-octyl, n-nonyl, and n-decyl, particularly preferred selected from methyl, and ethyl, most preferred methyl.

Preferred alkenyl groups are selected from alkenyl groups of 2 to 10 carbon atoms, preferably selected from vinyl, allyl, but-1-enyl, but-2-enyl, and but-3-enyl, particularly preferred from vinyl and allyl.

The preferred aryl group is an aryl group of 6 to 10 carbon atoms, preferably selected from phenyl and benzyl, most preferred phenyl.

Preferably, the curable composition according to the present invention further comprises filler.

Suitable filler is preferably selected from the group consisting of silica, alumina, magnesium oxide, aluminum hydroxide, titanium dioxide, potassium titanate, zirconium oxide, zinc sulfide, zinc oxide and magnesium oxide.

Hence, in one preferred embodiment of the present invention the curable composition comprises:
a) from 3 to 35 % by weight of the organic compound,
b) from 45 to 90 % by weight of the silicon hydride compound
c) from 0.0001 to 0.05 % by weight of the hydrosilylation catalyst,
d) from 0 to 50 % by weight of the organopolysiloxane,
e) from 0 to 50 % by weight of the filler,
the amount of all components a) to e) sums up to 100 wt-%.

Again, it is possible to add further additives, in particular the additives mentioned above.

Hence, in one preferred embodiment of the present invention the curable composition comprises:
a) from 3 to 35 % by weight of the organic compound,
b) from 45 to 90 % by weight of the silicon hydride compound
c) from 0.0001 to 0.05 % by weight of the hydrosilylation catalyst,
d) from 0 to 50 % by weight of the organopolysiloxane,
e) from 0 to 50 % by weight of the filler,
f) from 0 to 10 % by weight of at least one additive,
the amount of all components a) to f) sums up to 100 wt-%.

A further aspect of the present invention is the use of the curable composition in production of an optically semiconductor device, in particular a LED. Preferably, the curable composition is used as encapsulant, adhesive or lens forming material in the production of LEDs.

### Examples

As follows is a description of particular aspects of the present invention using a series of examples, however, the present invention is in no way restricted to the below presented examples.

### Test methods:

Hardness was measured with a LX-A and TH210 Shore durometer
Transmittance was measured by an UV-Visible spectrum analyzer Lambda 650S manufactured by PerkinElmer Corporation. The transmittance was measured for the range from 300 nm to 800 nm, and the value at 400 nm was recorded as the transmittance.

### Example 1:

5 g triallyl isocyanurate (from Sinopharm chemical reagent Co. Ltd.), 15 g 1,1,5,5-tetramethyl-3,3-diphenyl-trisiloxane (from Gelest), 0.01 g 3,5-dimethyl-1-hexyn-3-ol as reaction inhibitor, and platinum-divinyltetramethyldisiloxane complex as a catalyst with the platinum content being controlled to 80 ppm (by weight) are stirred, mixed and defoamed. The mixture was cured under 150°C for 5 hours.

The hardness of the resulting silicone material after curing was shore D 40, and the transparency at 400 nm was 88%.

After 150°C, 400nm UV aging for 24 hours, transparency at 400 nm was above 80%.

### Example 2:

1,1,7,7-tetramethyl-3,3,5,5-tetraphenyltetrasiloxane synthesis: 100 g diphenydimethoxy silane (from Sinopharm chemical reagent Co.Ltd.) and 55 g tetramethyl disiloxane were added into a three-neck bottle. 20 g 0.1 M HCI was added and heated the reaction at 60 °C for 4 hours. The organic phase was separated and evaporated under vacuum to give a colorless liquid polymer. The hydrogen content is 3.7mmol/g.

2 g triallyl isocyanurate (from Sinopharm chemical reagent Co.Ltd.), 6.8 g 1,1,7,7-tetramethyl-3,3,5,5-tetraphenyltetrasiloxane (synthesized as described above), 0.008 g 3,5-dimethyl-1-hexyn-3-ol as reaction inhibitor, and platinum-divinyltetramethyldisiloxane complex as a catalyst with the platinum content being controlled to 150 ppm (by weight) are sufficiently stirred, mixed and defoamed. The mixture was cured under 150°C for 16 hours.

The hardness of the resulting silicone material after curing was shore A 60, and the transparency at 400 nm was 90%.

After 150 °C, 400nm UV aging for 24 hours, transparency at 400 nm was above 80%.

### Example 3 (not inventive):

Hydride terminated polyphenyl-(dimethylsiloxy)siloxane synthesis: 100 g phenyltrimethoxy silane (from Sinopharm chemical reagent Co.Ltd.) and 20 g tetramethyl disiloxane were added into three-neck bottle. 20 g 0.1 M HCI was added and heated the reaction at 60 C for 4 hours. The organic phase was separated and evaporated under vacuum to give a colorless liquid polymer. The hydrogen content is 3.5mmol/g, 2 g triallyl isocyanurate (from Sinopharm chemical reagent Co.Ltd.), 7 g Polyphenyl-(dimethylsiloxy)siloxane, hydride terminated (synthesized in the lab), 0.009 g 3,5-dimethyl-1-hexyn-3-ol as reaction inhibitor, and platinum-divinyltetramethyldisiloxane complex as a catalyst with the platinum content being controlled at 200 ppm (by weight) are sufficiently stirred, mixed and defoamed.

The mixture was cured under 150°C for 2 hours.

The hardness of the resulting silicone material after curing was shore D 50, and the transparency at 400 nm was 89%.

After 150 °C, 400nm UV aging for 24 hours, transparency at 400 nm was above 80%.

### Example 4:

Tri-hexenyl isocyanurate synthesis: 100 ml DMF, 10 g 1, 3, 5-triazinane-2,4,6-trione (from Sinopharm chemical reagent Co.Ltd.) and 52 g 6-bromohexene (from Sinopharm chemical reagent Co.Ltd.) were added into three-neck bottle. 10.8 g NaOH was added and the reaction system was heated to 105C for 3 hours. Solvent was removed under reduced pressure. Toluene was added and washed with 1M HCI solution, distilled water and saturated NaCl solution. The organic phase was evaporated under vacuum. The desired product was purified by vacuum distillation, affording a colorless liquid (bp: 162-166 C/10 Pa, temperature of oil bath: 220 C). 5 g tri-hexenyl isocyanurate (synthesized in the lab), 10 g 1,1,5,5-Tetramethyl-3,3-diphenyl-trisiloxane (from Gelest), 0.01 g 3,5-dimethyl-1-hexyn-3-ol as reaction inhibitor, and platinum-divinyltetramethyldisiloxane complex as a catalyst with the platinum content being controlled at 80 ppm (by weight) are sufficiently stirred, mixed and defoamed.

The mixture was cured under 150°C for 5 hours.

The hardness of the resulting silicone material after curing was shore A 60, and the transparency at 400 nm was 88%.

### Example 5:

Tri-decenyl isocyanurate synthesis: 100 ml DMF, 10 g 1, 3, 5-triazinane-2,4,6-trione (from Sinopharm chemical reagent Co.Ltd.) and 70 g 10-bromo-1-decene (from Sinopharm chemical reagent Co.Ltd.) were added into three-neck bottle. 10.8 g NaOH was added and the reaction system was heated to 105C for 6 hours. Solvent was removed under reduced pressure. Toluene was added and washed with 1M HCl solution, distilled water and saturated NaCl solution. The organic phase was evaporated under vacuum. The desired product was purified by vacuum distillation, affording a colorless liquid (bp: 192-200 C/10 Pa, temperature of oil bath: 250 °C).

10 g tri-decenyl isocyanurate (synthesized in the lab), 10 g 1,1,5,5-Tetramethyl-3,3-diphenyl-trisiloxane (from Gelest), 0.01 g 3,5-dimethyl-1-hexyn-3-ol as reaction inhibitor, and platinum-divinyltetramethyldisiloxane complex as a catalyst with the platinum content being controlled at 180 ppm (by weight) are sufficiently stirred, mixed and defoamed. The mixture was cured under 150°C for 5 hours.

The hardness of the resulting silicone material after curing was shore A 50, and the transparency at 400 nm was 88%.

### Example 6:

1,3,5-Tris(allyloxyethyl)isocyanurate synthesis: 100 ml DMF, 30 g 1,3,5-Tris(2-hydroxyethyl) isocyanurate (from Sinopharm chemical reagent Co.Ltd.) and 55 g allylbromide (from Sinopharm chemical reagent Co.Ltd.) were added into three-neck bottle. 16 g NaOH was added and the reaction system was heated to 100C for 3 hours. Solvent was removed under reduced pressure. Toluene was added and washed with 1M HCI solution, distilled water and saturated NaCl solution. The organic phase was evaporated under vacuum. The desired product was purified by vacuum distillation, affording a colorless liquid (bp: 172-178 °C/15 Pa, temperature of oil bath: 220 °C).

7 g 1,3,5-Tris(allyloxyethyl)isocyanurate (synthesized in the lab), 10 g 1,1,5,5-Tetramethyl-3,3-diphenyl-trisiloxane (from Gelest), 0.01 g 3,5-dimethyl-1-hexyn-3-ol as reaction inhibitor, and platinum-divinyltetramethyldisiloxane complex as a catalyst with the platinum content being controlled at 200 ppm (by weight) are sufficiently stirred, mixed and defoamed. The mixture was cured under 150°C for 5 hours.

The hardness of the resulting silicone material after curing was shore A 50, and the transparency at 400 nm was 88%.

### Example 7 (not inventive):

Hydride terminated polyphenylene-(dimethylsiloxy)siloxane synthesis:
0.0024g platinum catalyst SIP 6832.2, 10g Divinyltetramethyldisiloxane and 23 g bis[(p-Dimethylsilyi)phenyl]ether (from Gelest) were added into a 100 mL dry and clean round bottom flask (three neck). A magnetic stirrer was added and the flask was capped with a stopper and a condenser. The reaction was kept at 75°C for 1 hour. And then the reaction was heated to 100°C for 3 hours. A clear liquid resin was obtained. The hydrogen content of this resin is 1.6 mmol/g.

1 g triallyl isocyanurate (from Sinopharm chemical reagent Co.Ltd.), 7.5 g Hydride terminated polyphenylene-(dimethylsiloxy)siloxane (synthesized in the lab), 0.008 g 3,5-dimethyl-1-hexyn-3-ol as reaction inhibitor, and platinum-divinyltetramethyldisiloxane complex as a catalyst with the platinum content being controlled at 100 ppm (by weight) are sufficiently stirred, mixed and defoamed.

The mixture was cured under 150°C for 10 hours.

The hardness of the resulting silicone material after curing was shore D 40, and the transparency at 400 nm was 89%.

After 150C, 400nm UV aging for 24 hours, transparency at 400 nm was above 80%.

### Example 8:

2 g triallyl isocyanurate (from Sinopharm chemical reagent Co.Ltd.), 8 g 1,1,5,5-tetramethyl-3,3-diphenyl-trisiloxane (from Gelest), 5 g phenylvinyl silicone resin (vinyl content is 3.5mmol/g, from Runhe Chemical) 0.01 g 3,5-dimethyl-1-hexyn-3-ol as reaction inhibitor, and platinum-divinyltetramethyldisiloxane complex as a catalyst with the platinum content being controlled at 150 ppm (by weight) are sufficiently stirred, mixed and defoamed. The mixture was cured under 150°C for 5 hours.

The hardness of the resulting silicone material after curing was shore D 40, and the transparency at 400 nm was 88%.

After 150 °C, 400nm UV aging for 24 hours, transparency at 400 nm was above 80%.

### Comparative Example:

5 g triallyl isocyanurate (from Sinopharm chemical reagent Co.Ltd.), 20 g hydride terminated polydimethylsiloxane (hydrogen content is 4mmol/g, from Sinopharm chemical reagent Co.Ltd), 0.01 g 3,5-dimethyl-1-hexyn-3-ol as reaction inhibitor, and platinum-divinyltetramethyldisiloxane complex as a catalyst with the platinum content being controlled at 100 ppm (by weight) are sufficiently stirred, mixed and defoamed.

The mixture was hazy and it was not possible to obtain a transparent sample.

## Claims

1. A curable composition, comprising:
a) at least one organic compound having two or more carbon-carbon double bonds which is represented by formula (1) 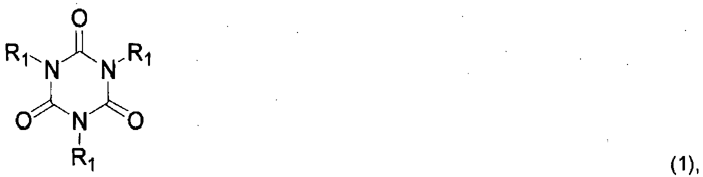 wherein R₁ at each occurrence independently from each other represents a monovalent organic group having 1 to 20 carbon atoms,
b) at least one silicon hydride compound selected from 1,1,5,5-tetramethyl-3,3-diphenyl-trisiloxane and 1,1,7,7-tetramethyl-3,3,5,5-tetraphenyltetrasiloxane, and mixture thereof, and
c) at least one hydrosilylation catalyst.

2. The curable composition according to claim 1, wherein in formula (1) at least two R₁ are selected from alkenyl groups and alkoxy alkyl groups bearing a terminal vinyl group.

3. The curable composition according to claim 1, wherein the organic compound is triallyl isocyanurate.

4. The curable composition according to claim 1, wherein the hydrosilylation catalyst is selected from the group of chloroplatinic acid, allylsiloxane-platinum complex catalyst, supported platinum catalysts, methylvinylsiloxane-platinum complex catalysts, reaction products of dicarbonyldichloroplatinum and 2,4,6-triethyl-2,4,6-trimethylcyclotrisiloxane.

5. The curable composition according to claim 4, wherein the platinum content is 1 to 500 ppm, and more preferably 2 to 100 ppm, based on the total weight of the curable composition.

6. The curable composition according to claim 1, comprising:
a) from 2 to 55 % by weight of the organic compound,
b) from 45 to 98 % by weight of the silicon hydride compound,
c) from 0.0001 to 0.05 % by weight of the hydrosilylation catalyst
wherein the amount of all components a) to c) sums up to 100-wt-%.

7. The curable composition according to claim 1, wherein the curable composition further comprises at least one organopolysiloxane represented by formula (3):
(R³R⁴R⁵SiO_{1/2})_{M}·(R⁶R⁷SiO_{2/2})_{D}·(R⁸SiO_{3/2})_{T}·(SiO_{4/2})_{Q} (3),
wherein R³ to R⁸ are identical or different groups independently from each other selected from alkyl groups, alkenyl groups and aryl groups, at least one of R³ to R⁸ is an alkenyl group, at least one of R³ to R⁸ is an aryl group, and on average at least two alkenyl groups and at least one aryl group are contained in each organopolysiloxane molecule;
M, D and Q each represent a number ranging from 0 to less than 1, 0< T <1 and M+D+T+Q = 1.

8. The curable composition according to claim 7, wherein R³ to R⁸ each independently are linear or branched C1-C20 alkyl or C2-C20 alkenyl groups, or halides of such linear or branched alkyl or alkenyl groups, or cycloalkyl groups or cycloalkenyl groups having 5-25 carbon atoms, respectively, or halides of such cycloalkyl groups or cycloalkenyl groups.

9. The curable composition according to claim 1, wherein the curable composition further comprises a filler.

10. The curable composition according to claim 9, wherein the filler is selected from the group consisting of silica, alumina, magnesium oxide, aluminum hydroxide, titanium dioxide, potassium titanate, zirconium oxide, zinc sulfide, zinc oxide and magnesium oxide.

11. The curable composition according to at least one of claims 1 to 10, comprising:
a) from 3 to 35 % by weight of the organic compound,
b) from 45 to 90 % by weight of the silicon hydride compound
c) from 0.0001 to 0.05 % by weight of the hydrosilylation catalyst,
d) from 0 to 50 % by weight of the organopolysiloxane,
e) from 0 to 50 % by weight of the filler,
wherein the amount of all components a) to e) sums up to 100 wt-%.

12. The use of the curable composition according to claims 1 to 11 in production of an optically semiconductor device.

## Patentansprüche

1. Härtbare Zusammensetzung, umfassend:
a) mindestens eine organische Verbindung mit zwei oder mehreren Kohlenstoff-KohlenstoffDoppelbindungen, dargestellt durch die Formel (1) 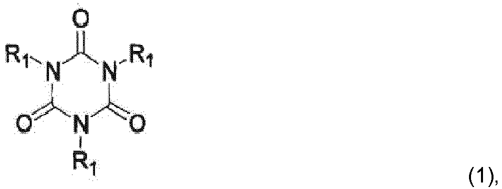 wobei R₁ bei jedem Auftreten unabhängig voneinander eine monovalente organische Gruppe mit 1 bis 20 Kohlenstoffatomen darstellt,
b) mindestens eine Siliciumhydridverbindung, ausgewählt aus 1,1,5,5-Tetramethyl-3,3-diphenyl-trisiloxan und 1,1,7,7-Tetramethyl-3,3,5,5-tetraphenyltetrasiloxan, und einer Mischung davon und
c) mindestens einen Hydrosilylierungskatalysator.

2. Härtbare Zusammensetzung nach Anspruch 1, wobei in Formel (1) mindestens zwei R₁ ausgewählt sind aus Alkenylgruppen und Alkoxyalkylgruppen, die eine endständige Vinylgruppe tragen.

3. Härtbare Zusammensetzung nach Anspruch 1, wobei die organische Verbindung Triallylisocyanurat ist.

4. Härtbare Zusammensetzung nach Anspruch 1, wobei der Hydrosilylierungskatalysator ausgewählt ist aus der Gruppe von Chlorplatinsäure, Allylsiloxan-Platin-Komplexkatalysator, geträgerten Platinkatalysatoren, Methylvinylsiloxan-Platin-Komplexkatalysatoren, Reaktionsprodukten von Dicarbonyldichlorplatin und 2,4,6-Triethyl-2,4,6-Trimethyl-cyclotrisiloxan.

5. Härtbare Zusammensetzung nach Anspruch 4, wobei der Platingehalt 1 bis 500 ppm und insbesondere 2 bis 100 ppm, bezogen auf das Gesamtgewicht der härtbaren Zusammensetzung, beträgt.

6. Härtbare Zusammensetzung nach Anspruch 1, umfassend:
a) 2 bis 55 Gew.-% der organischen Verbindung,
b) 45 bis 98 Gew.-% der Siliciumhydridverbindung,
c) von 0,0001 bis 0,05 Gew.-% des Hydrosilylierungskatalysators, wobei die Menge aller Komponenten a) bis c) zusammen 100 Gew.-% beträgt.

7. Härtbare Zusammensetzung nach Anspruch 1, wobei die härtbare Zusammensetzung ferner mindestens ein Organopolysiloxan der Formel (3) umfasst:
(R³R⁴R⁵SiO_{1/2})_{M}·(R⁶R⁷SiO_{2/2})_{D}·(R⁸SiO_{3/2})_{T}·(SiO_{4/2})_{Q} (3),
wobei R³ bis R⁸ gleiche oder verschiedene Gruppen unabhängig voneinander sind, ausgewählt aus Alkylgruppen, Alkenylgruppen und Arylgruppen, mindestens einer von R³ bis R⁸ eine Alkenylgruppe ist, mindestens einer von R³ bis R⁸ eine Arylgruppe ist, und im Durchschnitt mindestens zwei Alkenylgruppen und mindestens eine Arylgruppe in jedem Organopolysiloxan-Molekül enthalten sind;
M, D und Q jeweils eine Zahl im Bereich von 0 bis weniger als 1 darstellen, 0< T <1 und M+D+T+Q = 1.

8. Härtbare Zusammensetzung nach Anspruch 7, wobei R³ bis R⁸ jeweils unabhängig voneinander lineare oder verzweigte C1-C20-Alkyl- oder C2-C20-Alkenylgruppen sind, oder Halogenide solcher linearen oder verzweigten Alkyl- oder Alkenylgruppen oder Cycloalkylgruppen oder Cycloalkenylgruppen mit jeweils 5-25 Kohlenstoffatomen oder Halogenide solcher Cycloalkylgruppen oder Cycloalkenylgruppen.

9. Härtbare Zusammensetzung nach Anspruch 1, wobei die härtbare Zusammensetzung ferner einen Füllstoff umfasst.

10. Härtbare Zusammensetzung nach Anspruch 9, wobei der Füllstoff ausgewählt ist aus der Gruppe bestehend aus Siliciumdioxid, Aluminiumoxid, Magnesiumoxid, Aluminiumhydroxid, Titandioxid, Kaliumtitanat, Zirkonoxid, Zinksulfid, Zinkoxid und Magnesiumoxid.

11. Härtbare Zusammensetzung nach mindestens einem der Ansprüche 1 bis 10, umfassend:
a) 3 bis 35 Gew.-% der organischen Verbindung,
b) 45 bis 90 Gew.-% der Siliciumhydridverbindung
c) von 0,0001 bis 0,05 Gew.-% des Hydrosilylierungskatalysators,
d) von 0 bis 50 Gew.-% des Organopolysiloxans,
e) von 0 bis 50 Gew.-% des Füllstoffs,
wobei die Menge aller Komponenten a) bis e) zusammen 100 Gew.-% beträgt.

12. Verwendung der härtbaren Zusammensetzung nach den Ansprüchen 1 bis 11 bei der Herstellung einer optischen Halbleitervorrichtung.

## Revendications

1. Composition durcissable comprenant :
a) au moins un composé organique ayant deux doubles liaisons carbone-carbone ou plus, représenté par la formule (1) 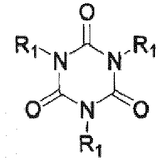 dans laquelle R₁, à chaque occurrence indépendamment les unes des autres, représente un groupe organique monovalent ayant de 1 à 20 atomes de carbone,
b) au moins un composé d'hydrure de silicium choisi parmi
le 1,1,5,5-tétraméthyl-3,3-diphényl-trisiloxane et
le 1,1,7,7-tétraméthyl-3,3,5,5-tétraphényltétrasiloxane, et les mélanges de ceux-ci, et
c) au moins un catalyseur d'hydrosilylation.

2. Composition durcissable selon la revendication 1, dans laquelle, dans la formule (1), au moins deux R₁ sont choisis parmi les groupes alcényle et les groupes alcoxy alkyle portant un groupe vinyle terminal.

3. Composition durcissable selon la revendication 1, dans laquelle le composé organique est l'isocyanurate de triallyle.

4. Composition durcissable selon la revendication 1, dans laquelle le catalyseur d'hydrosilylation est choisi dans le groupe constitué par l'acide chloroplatinique, le catalyseur complexe allylsiloxane-platine, les catalyseurs au platine sur support, les catalyseurs complexes au méthylvinylsiloxane-platine, les produits de réaction du dicarbonyldichloroplatine et du 2,4,6-triéthyl-2,4,6-triméthylcyclotrisiloxane.

5. Composition durcissable selon la revendication 4, dans laquelle la teneur en platine se situe dans la plage allant de 1 à 500 ppm, et de manière davantage préférée de 2 à 100 ppm, sur la base du poids total de la composition durcissable.

6. Composition durcissable selon la revendication 1, comprenant :
a) de 2 à 55 % en poids du composé organique,
b) de 45 à 98 % en poids du composé d'hydrure de silicium,
c) de 0,0001 à 0,05 % en poids du catalyseur d'hydrosilylation
la quantité de tous les constituants a) à c) s'élevant à 100 % en poids.

7. Composition durcissable selon la revendication 1, dans laquelle la composition durcissable comprend en outre au moins un organopolysiloxane représenté par la formule (3) :
(R³R⁴R⁵SiO_{1/2)M}.(R⁶R⁷SiO_{2/2})D.(R⁸SiO_{3/2})_{T}.(SiO_{4/2})_{Q} (3),
dans laquelle R³ à R⁸ sont des groupes identiques ou différents choisis indépendamment les uns des autres parmi les groupes alkyle, les groupes alcényle et les groupes aryle, au moins l'un de R³ à R⁸ est un groupe alcényle, au moins l'un de R³ à R⁸ est un groupe aryle, et en moyenne au moins deux groupes alcényle et au moins un groupe aryle sont présents dans chaque molécule d'organopolysiloxane ;
M, D et Q représentent chacun un nombre situé dans la plage allant de 0 à moins de 1, 0<T<1 et M+D+T+Q = 1.

8. Composition durcissable selon la revendication 7, dans laquelle R³ à R⁸ sont chacun indépendamment des groupes alkyle en C₁ à C₂₀ ou alcényle en C₂ à C₂₀ linéaires ou ramifiés, ou des halogénures de ces groupes alkyle ou alcényle linéaires ou ramifiés, ou des groupes cycloalkyle ou des groupes cycloalcényle ayant de 5 à 25 atomes de carbone, respectivement, ou des halogénures de ces groupes cycloalkyle ou cycloalcényle.

9. Composition durcissable selon la revendication 1, la composition durcissable comprenant en outre une charge.

10. Composition durcissable selon la revendication 9, dans laquelle la charge est choisie dans le groupe constitué par la silice, l'alumine, l'oxyde de magnésium, l'hydroxyde d'aluminium, le dioxyde de titane, le titanate de potassium, l'oxyde de zirconium, le sulfure de zinc, l'oxyde de zinc et l'oxyde de magnésium.

11. Composition durcissable selon au moins l'une des revendications 1 à 10, comprenant :
a) de 3 à 35 % en poids du composé organique,
b) de 45 à 90 % en poids du composé d'hydrure de silicium,
c) de 0,0001 à 0,05 % en poids du catalyseur d'hydrosilylation,
d) de 0 à 50 % en poids de l'organopolysiloxane,
e) de 0 à 50 % en poids de la charge,
la quantité de tous les constituants a) à e) s'élevant à 100 % en poids.

12. Utilisation de la composition durcissable selon les revendications 1 à 11 dans la production d'un dispositif optiquement semi-conducteur.
